# EUROPÄISCHE PATENTSCHRIFT

(11) **EP 3 123 503 B1**
(45) Veröffentlichungstag und Bekanntmachung des Hinweises auf die Patenterteilung: **16.10.2019**
(21) Anmeldenummer: 15700204.9
(22) Anmeldetag: 09.01.2015
(51) Int. Cl.: H01L 21/768

(54) **VERFAHREN ZUR BESCHICHTUNG VON KAVITÄTEN EINES HALBLEITERSUBSTRATS**
METHOD FOR COATING CAVITIES OF A SEMICONDUCTOR SUBSTRATE
PROCÉDÉ POUR LE REVÊTEMENT DE CAVITÉS D'UN SUBSTRAT SEMI-CONDUCTEUR

(30) Priorität: 26.03.2014 DE 102014104239
(43) Veröffentlichungstag der Anmeldung: 01.02.2017
(73) Patentinhaber: Ev Group E. Thallner GmbH, 4782 St. Florian am Inn (AT)
(72) Erfinder: FEHKÜHRER, Andreas, A-4973 Senftenbach (AT)
(74) Vertreter: Schneider, Sascha
(86) Internationale Anmeldenummer: PCT/EP2015/050283
(87) Internationale Veröffentlichungsnummer: WO 2015/144319

(56) Entgegenhaltungen:
- WO-A2-2007/054867
- US-A1- 2010 120 260
- US-A1- 2010 301 491
- US-A1- 2013 034 816
- CUI HUANG ET AL: "Implementation of Air-Gap Through-Silicon-Vias (TSVs) Using Sacrificial Technology", IEEE TRANSACTIONS ON COMPONENTS, PACKAGING AND MANUFACTURING TECHNOLOGY, IEEE, USA, Bd. 3, Nr. 8, 1. August 2013 (2013-08-01), Seiten 1430-1438, XP011522977, ISSN: 2156-3950, DOI: 10.1109/TCPMT.2013.2265211

## Beschreibung

Die vorliegende Erfindung betrifft ein Verfahren zur Beschichtung von, ein Halbleitersubstrat zumindest teilweise durchsetzenden, Kavitäten mit einem Beschichtungsmaterial gemäß Anspruch 1 sowie ein Verfahren zur Entfernung einer Beschichtung aus Kavitäten eines Halbleitersubstrats.

In der Halbleiterindustrie zeichnet sich der Trend nach dreidimensionalen Strukturen schon seit einigen Jahren ab. Obwohl man bereits vor mehr als zehn Jahren mit dem Stapeln unterschiedlicher funktioneller Einheiten begonnen hat, konnten die Verbindungen zwischen diesen Strukturen nur aufwendig durch eine äußere Verdrahtung durchgeführt werden. Diese Verdrahtungen (eng.: wires) wurden durch Drahtbonder (engl.: wire bonder) durchgeführt. Die Verdrahtungen sind teuer, fehleranfällig und nehmen entsprechend viel Platz in Anspruch.

Seit einigen Jahren wird daher an Technologien gearbeitet, bei denen die Verdrahtung der unterschiedlichen funktionalen Einheiten vertikal durch ein Substrat oder durch einen Chip erfolgt. Diese Durchgänge nennt man Vias. Vias in Silizium werden als TSVs (engl.: through silicon Vias), im Polymer TPVs (engl.: through polymer Vias) genannt.

Allen Via-Technologien ist gemein, dass sie in einem Grundsubstrat durch Bohren, Fräsen oder - auf Grund der meist sehr kleinen Dimensionen bevorzugt - durch Ätzen hergestellt werden. Je kleiner die Vias, desto aufwendiger ist die Herstelltechnologie. Da man heute bereits Vias im µm-Maßstab herstellt, kommen praktisch nur noch Bohr- und Ätztechniken in Betracht.

Bei den Bohrtechniken werden überwiegend Laserbohrer verwendet. Hochenergetische, extrem kollimierte Laserstrahlen erzeugen eine derart große, örtlich stark begrenzte Wärme, dass das Grundmaterial verdampft. Durch das Laserbohren können Vias mit sehr großen Aspektverhältnissen von Durchmesser zu Tiefe geschaffen werden. Die Laserbohrtechnik kommt vorwiegend bei Polymeren zum Einsatz. Die Vias durch die Polymere bezeichnet man als "through-polymer-vias" oder einfach nur als TPVs. Die Polymere sind viel leichter thermisch zersetzbar als Metalle oder Halbleitermaterialien.

Eine weitere Herstellungsart ist das Ätzen der Vias. Bei der Verwendung von Ätztechniken müssen die Oberflächen der zu ätzenden Substrate zuerst maskiert und dann mit der jeweiligen Chemikalie behandelt werden.

Nach der Herstellung der Vias existieren mehrere Möglichkeiten der Füllung. Einerseits kann nur die Oberfläche der Vias metallisch beschichtet werden, um so einen Hohlleiter zu erzeugen. Andererseits können die Vias vollständig gefüllt werden. Die Wahl der Beschichtung hängt hauptsächlich von der Verwendung der Vias ab. Volumengefüllte Vias eignen sich vorzugsweise besser für höhere Stromdichten, während Hohlleiter-Vias sich für andere elektronische Belastungsarten besser verwenden lassen.

Ein Problem im Stand der Technik besteht darin, dass zwischen dem Prozessschritt der Via-Herstellung und dem Prozessschritt der Via-Beschichtung oder -Bestückung andere Prozessschritte auf das Substrat angewendet werden können oder angewendet werden müssen. Diese zwischengeschalteten Prozessschritte verunreinigen nicht selten die hergestellten Vias. Obwohl die Verschmutzung der Vias recht schnell erfolgt, ist die entsprechende und notwendige Reinigung teuer, zeitaufwendig und nicht selten unvollständig. Ein nicht korrekt gereinigter Via kann im schlimmsten Fall nicht korrekt beschichtet werden und führt damit zu Ausschuss.

Wenn beispielsweise eine funktionale Einheit mit 20 Vias mit einer zweiten funktionalen Einheit verbunden ist, reicht die Verunreinigung eines einzelnen Vias, um die gesamte funktionale Einheit unbrauchbar zu machen. Durch die Verunreinigung von Vias sinkt damit die entsprechende Ausbeute und die Stückpreiskosten steigen.

Unter allen möglichen Prozessschritten, die zu einer Verunreinigung der Vias führen, sticht vor allem die Beschichtung der Substratoberfläche mit einem temporären Kleber hervor. Temporäre Kleber, sogenannte Bondingadhäsive, sind Polymere, deren Aufgabe darin besteht, ein Produktsubstrat, insbesondere einen Produktwafer, mit einem Trägersubstrat, insbesondere einem Trägerwafer, temporär miteinander zu verbinden. Bereits im Produktsubstrat vorhandene Vias können vom Temporärkleber verunreinigt werden. Nachdem das Produktsubstrat weiterprozessiert und schließlich wieder vom Trägersubstrat entfernt wurde, müssen die verunreinigten Vias gereinigt werden. Die chemischen Eigenschaften des Temporärklebers wirken sich besonders nachteilig auf die Reinigung der Vias aus, da der Temporärkleber (vor allem bei niedrigen Temperaturen) eine hohe Viskosität besitzt. Die hohe Viskosität des Temporärklebers bei Raumtemperatur, insbesondere bei 20°C, ist für den eigentlichen Temporärbondprozess erwünscht, um das Produktsubstrat fest mit dem Trägersubstrat zu verbinden. Bei den meisten Debondprozessen muss die Temperatur zum Entfernen von Produkt- und Trägersubstrat erhöht werden, um die Viskosität des Temporärklebers zu erniedrigen. Da der Reinigungsprozess allerdings dem Debondprozess folgt und nicht gleichzeitig durchgeführt werden kann, steigt die Viskosität im Allgemeinen durch ein Absinken der Temperatur zwischen dem Debond und dem Reinigungsprozess wieder auf einen sich auf die Reinigung negativ auswirkenden, sehr hohen Wert. Bei Debondprozessen, die bei Raumtemperatur durchgeführt werden, erreicht der Temporärbondkleber nie einen niedrigen Viskositätswert.

Um die Vias überhaupt reinigen zu können, müssen die Produktsubstrate nach dem Debonden in ein chemisches Bad gelegt und insbesondere mit Ultraschall beaufschlagt werden. Beide Behandlungsschritte beanspruchen das Produktsubstrat, kosten vor allem Zeit und erhöhen damit die Kosten.

Das Dokument WO2007/054867 beschreibt ein Verfahren zur Herstellung von Substratdurchkontaktierungen, wobei Sacklöcher gebildet werden, die vor der Durchführung weiterer Bearbeitungsschritte mit einem temporären Beschichtungsmaterial teilweise gefüllt werden.

Aufgabe der vorliegenden Erfindung ist es, ein Verfahren anzugeben, mit dem die Bearbeitung von Halbleitersubstraten mit Kavitäten, insbesondere Vias, optimiert wird.

Die vorliegende Aufgabe wird mit den Merkmalen des Anspruchs 1 gelöst. Vorteilhafte Weiterbildungen der Erfindung sind in den Unteransprüchen angegeben.

Die Erfindung betrifft einerseits ein Verfahren zur temporären Beschichtung einer Oberfläche von ein Halbleitersubstrat zumindest teilweise, vorzugsweise überwiegend (mehr als bis zur halben Dicke des Halbleitersubstrats), durchsetzenden Kavitäten. Kavitäten sind insbesondere Vias, mit Vorzug Bohrungen, Durchgangslöcher, Kontaktlöcher im Allgemeinen aber jede Art von Vertiefung in Bezug zur Oberfläche des Substrats. Vias werden insbesondere erzeugt, um sie mit einem Elektrikum, insbesondere einem Metall, meistens Kupfer, permanent zu beschichten oder aufzufüllen, sodass eine leitfähige Verbindung zwischen den beiden Halbleitersubstraten entsteht. Kavitäten werden insbesondere auch zur Bestückung mit oder zur Aufnahme von funktionalen Bauteilen, vorzugsweise LEDs oder MEMs verwendet.

Die Aufgabe der temporären Beschichtung besteht insbesondere in einer einfachen, schnellen und vor allem kostengünstigen Entfernung von Fremdstoffen, die während eines oder mehrerer Prozessschritte in die Kavitäten/Vias eindringen können. Erfindungswesentlich ist es daher, die Beschichtung vor der Bearbeitung mindestens einer Oberfläche des Halbleitersubstrats und damit vor einer Verunreinigung durchzuführen.

Ein solcher Bearbeitungsschritt ist insbesondere die Beschichtung mindestens einer der Oberflächen des Halbleitersubstrats, vorzugsweise mit einem Bondingadhäsiv. Folgende Bearbeitungsschritte sind erfindungsgemäß alternativ oder kumulativ zu den oben genannten denkbar:
- Mechanische Oberflächenbearbeitungen
   ∘ Schleifen
   ∘ Polieren
- Behandlung mit Flüssigkeiten
   ∘ Ätzen
   ∘ Waschen
- Beschichtungen
   ∘ Gasphasenabscheidungen wie PVD, CVD, PECVD
   ∘ Molekularstrahlenabscheidungen
   ∘ Elektrochemische Abscheidungen
   ∘ Sputtern
   ∘ Aufbringen von Polymeren
      ■ Temporärkleber
      ■ Belacken mit Fotolack, sogenanntem Resist

Die Erfindung beschreibt somit insbesondere eine Methode, die Kavitäten/Vias vor einem Prozessschritt, der die Kavitäten/Vias verunreinigen könnte, mit einem Material zu beschichten, welches eine geringe Adhäsionsfähigkeit zu anderen Materialien besitzt, vorzugsweise leicht entfernt werden kann. Des Weiteren verhindert oder erschwert die erfindungsgemäße Beschichtung zumindest die Ablagerung und das Anhaften von Verunreinigungen an der Oberfläche der Kavitäten.

Gemäß einem eigenen Erfindungsaspekt betrifft die Erfindung ein Verfahren zur Entfernung einer Beschichtung von Kavitäten/Vias eines Halbleitersubstrats, wobei die Beschichtung insbesondere nach einem vorbeschriebenen Verfahren aufgebracht ist/wird. Die Entfernung erfolgt insbesondere nach den oben genannten Bearbeitungsschritten, wobei mit der Entfernung insbesondere auch etwaige Verunreinigungen entfernt, vorzugsweise aus den Kavitäten/Vias ausgetragen, werden. Insbesondere unmittelbar nach der Entfernung erfolgt die permanente Beschichtung/Bestückung der Vias/Kavitäten/.

Die Beschichtung besteht insbesondere aus einem Material, das leichter entfernt werden kann als durch die Bearbeitungsschritte erzeugte Verunreinigungen. Im Speziellen werden die Beschichtung und/oder die Verunreinigungen mehr als 1 mal, mit Vorzug mehr als 10 mal, mit größerem Vorzug mehr als 50 mal, mit größtem Vorzug mehr als 100 mal, mit allergrößtem Vorzug mehr als 1000 mal so schnell entfernt, wie die Entfernung der Verunreinigung ohne die erfindungsgemäße Beschichtung stattfinden würde. Insbesondere können der Reinigungsschritt der Verunreinigungen und die Entfernung der erfindungsgemäßen temporären Beschichtung getrennt voneinander stattfinden. Das ist vor allem dann von Vorteil, wenn zwischen der Herstellung der erfindungsgemäßen Beschichtung und deren endgültiger Entfernung mehrere Prozessschritte liegen, welche die Kavitäten/Vias verunreinigen. In einer ganz besonders bevorzugten Ausführungsform werden allerdings Verunreinigungen und temporäre Beschichtung gleichzeitig entfernt.

Ein weiterer erfindungsgemäßer Aspekt ist die bevorzugte Entfernung der Verunreinigungen aus den Kavitäten/Vias bei möglichst niedrigen Temperaturen und insbesondere in einer chemisch neutralen und/oder nichtbasischen und/oder nicht-sauren und/oder nicht-toxischen Umgebung.

Die Temperatur zur Entfernung der Verunreinigungen aus den Kavitäten/Vias liegt insbesondere bei weniger als 500°C, mit Vorzug weniger als 300°C, mit größtem Vorzug bei weniger als 100°C, am bevorzugtesten bei Raumtemperatur.

Die Erfindung beschreibt in Kombination insbesondere ein Verfahren, die Oberfläche von Kavitäten/Vias des Halbleitersubstrats zu beschichten, um eine nach mehreren Bearbeitungsschritten möglicherweise stattgefundene Verunreinigung der Kavitäten/Vias schneller entfernen zu können. Die Kavitäten/Vias werden insbesondere mit der Beschichtung nicht ausgefüllt, sondern bevorzugt wird nur eine im Verhältnis zum Durchmesser der Kavitäten/Vias dünne Beschichtung aufgetragen. Unter der Voraussetzung eines, insbesondere radialsymmetrischen, VIAS ist das Verhältnis zwischen der Beschichtungsdicke und dem Radius des VIAS kleiner als 0.5, mit Vorzug kleiner als 0.1, mit größerem Vorzug kleiner als 0.01, mit größtem Vorzug kleiner als 0.001, mit allergrößtem Vorzug kleiner als 0.0001. Die Beschichtungsdicke ist insbesondere kleiner als 1 µm, mit größerem Vorzug kleiner als 100nm, mit größtem Vorzug kleiner als 10nm, mit allergrößtem Vorzug kleiner als 1nm, am allerbevorzugtesten besteht die Beschichtungsdicke nur aus einer einzigen Monolage des Beschichtungsmaterials.

Die erfindungsgemäße Ausführungsform eignet sich grundsätzlich für alle Arten von Kavitäten. Im weiteren Verlauf der Patentschrift wird eine besondere Kavitätenart, die Vias stellvertretend für alle Arten von Kavitäten beschrieben. Dem Fachmann auf dem Gebiet ist klar, dass sich die erfindungsgemäße Methode aber nicht nur auf Vias beschränkt, sondern für jede Art von Kavität Verwendung finden kann. Die Verwendung bei Vias stellt die erfindungsgemäß bevorzugte Ausführungsform dar.

Ein erfindungsgemäßer Aspekt besteht darin, ein Beschichtungsmaterial zu verwenden, das folgende Eigenschaften besitzt. Das Beschichtungsmaterial eignet sich für die Beschichtung der zu beschichtenden Oberfläche des Halbleitersubstrats, ist bevorzugt möglichst kostengünstig und zumindest bis zur Reinigung der Kavitäten/Vias stabil. Unter Stabilität wird erfindungsgemäß verstanden, dass die Adhäsion zwischen der Oberfläche der Kavitäten/Vias möglichst hoch ist. Die Adhäsion wird vorzugsweise über die Energie pro Flächeneinheit definiert, die notwendig ist, um zwei miteinander verbundene Oberflächen voneinander zu trennen. Die Energie wird dabei in J/m² angegeben. Die Energie pro Einheitsfläche ist insbesondere größer als 0.00001 J/m², mit Vorzug größer als 0.0001 J/m², mit größerem Vorzug größer als 0.001 J/m², mit größtem Vorzug größer als 0.01 J/m², mit allergrößtem Vorzug größer als 0.1 J/m², am bevorzugtesten größer als 2.5 J/m². Des Weiteren ist unter Stabilität zu verstehen, dass sich die Beschichtung während weiterer Prozessschritte nicht bezüglich ihrer physikalischen und/oder chemischen Eigenschaften ändert. Des Weiteren weist das Beschichtungsmaterial eine zu anderen Materialien, insbesondere Verunreinigungen aus zwischen der temporären Beschichtung und der permanenten Beschichtung/Bestückung Bearbeitungsschritten, niedrig adhäsive Eigenschaft auf, zumindest aber zu allen Materialien, die während weiterer Prozessschritte die Kavitäten/Vias verunreinigen können. Darunter fallen insbesondere folgende Materialien:
- Organische Materialien, insbesondere
   ∘ Polymere, vorzugsweise
      ■ Thermoplaste, bevorzugt
         - Temporärkleber und/oder
      ■ Duroplase und/oder
      ■ Elastomere und/oder
      ■ Fotolacke und/oder
   ∘ Kohlenstoffverbindungen, insbesondere
      ■ Graphite und/oder
      ■ Buckminsterfullerene und/oder
      ■ Graphen und/oder
      ■ Karbonanoröhren und/oder
- Anorganische Materialien, insbesondere
   ∘ Metalle und/oder
      ■ Al, Pt, Au, Ag, Cu, W, Zn, Sn, Pb, Mo, Ti, Fe und/oder
   ∘ Halbleiter, insbesondere
      ■ - III-V: GaP, GaAs, InP, InSb, InAs, GaSb, GaN, AlN, InN, AlₓGa₁₋ₓAs, InₓGa₁₋ₓN und/oder
      ■ - IV-IV: SiC, SiGe und/oder
      ■ - III-VI: InAlP und/oder
   ∘ Keramiken und/oder
- Flüssigkeiten, insbesondere
   ∘ Säuren und/oder Basen.
- Adsorbierende Gase

Des Weiteren besitzt das Beschichtungsmaterial eine geringe Adhäsionsfähigkeit zu den Verunreinigungen, die sich in den Vias ablagern können. Die Energie des Beschichtungsmaterials oder der Beschichtung pro Einheitsfläche ist insbesondere geringer als 2.5 J/m2, mit Vorzug kleiner als 0.1 J/m2, mit größerem Vorzug kleiner als 0,01 J/m2, mit größtem Vorzug kleiner als 0.001 J/m2, mit allergrößtem Vorzug kleiner als 0.0001 J/m2, am bevorzugtesten kleiner als 0.00001 J/m2.

Das Beschichtungsmaterial ist erfindungsgemäß aus einem hochadhäsiven Teil, der an der Oberfläche der Vias anhaftet, und einem niedrigadhäsiven Teil, der in das Innere der Vias zeigt und damit mit den Verunreinigungen in Kontakt kommt, gebildet.

Mit Vorzug erfolgt die Auftragung der Beschichtung durch einen Schleuderbelackungsprozess, allerdings können andere Beschichtungsverfahren, vor allem solche, die sich für Batchprozesse eignen, verwendet werden, insbesondere:
- Sprühbelackung
- Tauchbeschichtung
- Elektrochemische Deposition
- Beschichtung durch Fällungsreaktionen

Mit Vorzug handelt es sich bei dem Beschichtungsmaterial um eine molekulare organische Verbindung. Mit größerem Vorzug handelt es sich um ein Antihaftschichtmaterial. Mit größtem Vorzug handelt es sich um eines der folgenden Materialien:
- Polymere, insbesondere
   ∘ Fluoropolymere, vorzugsweise
      ■ Nicht gelöst in Lösungsmittel oder
      ■ Gelöst in Lösungsmittel (bevorzugt), insbesondere
         - gelöst in Hydrofluoroetherlösungsmittel.

Gemäß einer vorteilhaften Ausführungsform der vorliegenden Erfindung wird das Beschichtungsmaterial mit einer Beschichtungsdicke b kleiner gleich als der halbe mittlere Durchmesser D der Kavitäten zumindest auf einen Innenumfang und einen Boden der Kavitäten aufgebracht. Die Beschichtung wird höchst homogen aufgebracht, wobei die Beschichtungsdicke d als mittlere Beschichtungsdicke anzusehen ist. Die Kavitäten sind bevorzugt zylinderförmige Kavitäten, wobei als Durchmesser D der mittlere Durchmesser des Zylinders anzusehen ist, wobei insbesondere an einem Übergang zum Boden der Kavitäten vorhandene Schrägen oder Abrundungen unberücksichtigt bleiben. Im Fall der vollständigen Ausfüllung der Kavitäten/Vias dient das Material als Schutzbarriere um ein Eindringen von Verunreinigungen überhaupt gänzlich zu verhindern. Diese nicht erfindungsgemäße Ausführungsform ist nur dann technisch und ökonomisch sinnvoll, wenn das so verwendete Beschichtungsmaterial auch wieder extrem schnell und vor allem unproblematisch aus der Kavität/Via entfernt werden kann, da das Beschichtungsmaterial sonst selbst eine Verunreinigung darstellt.

Das Beschichtungsmaterial kann insbesondere zunächst vollflächig aufgetragen werden und durch Rotation des Substrats überschüssiges Beschichtungsmaterial ausgetragen werden, so dass eine homogene Beschichtung verbleibt. Mit besonderem Vorzug wird das Beschichtungsmaterial durch die Methode aufgebracht, die in der Druckschrift US 8.586,132 B2 erwähnt wird. Diese Methode eignet sich insbesondere zur Beschichtung von Vias.

Erfindungsgemäß ist es, wenn das Beschichtungsmaterial bei der Beschichtung zusätzlich an zwischen den Kavitäten verlaufenden Zwischenflächen des Halbleitersubstrats aufgebracht wird. Somit werden nicht nur die Kavitäten geschützt, was insbesondere bei bestimmten, sich anschließenden Prozessierungs- oder Bearbeitungsschritten von Vorteil sein kann.

Nach, zwischen oder vor etwaigen, der Beschichtung nachgelagerten Bearbeitungs- oder Prozessierungsschritten wird das Beschichtungsmaterial an den Zwischenflächen nach der Beschichtung, insbesondere vollständig, entfernt, ohne das in den Kavitäten aufgebrachte Beschichtungsmaterial zu entfernen. Auf diese Weise liegen die möglicherweise zu bearbeitenden Zwischenflächen des Halbleitersubstrats für die Bearbeitung frei, während der Innenumfang und der Boden der Kavitäten durch das Beschichtungsmaterial geschützt ist. Die Abtragung des Beschichtungsmaterials erfolgt dabei durch Abschleudern.

Das Abschleudern, insbesondere durch einen Spinätzprozess, kann insbesondere in Verbindung mit der Aufbringung eines Lösungsmittels erfolgen, um das Beschichtungsmaterial, zumindest teilweise, vorzugsweise vollständig, zu entfernen. Bei einem teilweisen Entfernen des Beschichtungsmaterials an den, insbesondere in einer Ebene angeordneten, Zwischenflächen wird bevorzugt ausschließlich ein ringförmiger Wandabschnitt der Oberfläche des Halbleitersubstrats von dem Beschichtungsmaterial befreit.

Auf diese Weise kann ein Randabschnitt mit einem Klebematerial beaufschlagt werden, um das Halbleitersubstrat nur in diesem Randabschnitt mit einem anderen Substrat zu fixieren. Bei vollständiger Entfernung des Lösungsmittels an den Zwischenflächen verbleibt eine vom Beschichtungsmaterial befreite ebene Fläche, die weiteren Bearbeitungsschritten gegenüber offen ist.

Ein weiterer, insbesondere eigenständiger Erfindungsaspekt ist die Reinigung eines mit einem oben beschriebenen Verfahren beschichteten und mit Bearbeitungsschritten bearbeiteten Substrats. Bei den Bearbeitungsschritten erfolgt insbesondere ein Eintrag von Verunreinigungen, insbesondere Kleber (beispielsweise Bondingadhäsiv), die vor allen Dingen in die Kavitäten eindringen können. Durch die erfindungsgemäße Beschichtung wird die Reinigung stark vereinfacht und beschleunigt. Eine besonders bevorzugte Entfernung der Verunreinigung aus den Kavitäten/Vias erfolgt allerdings vorzugsweise mit Ultraschalleinwirkung, während sich das Substrat in einem Lösungsmittel befindet.

Ein erfindungsgemäßer Aspekt besteht insbesondere darin, dass ein optional verwendeter Ultraschall die Kavitäten/Vias, im Gegensatz zum Stand der Technik, auf Grund der extrem geringen Adhäsion zwischen der Beschichtung und der Verunreinigung, in einer extrem kurzen Zeit von den Verunreinigungen befreien kann. Der erfindungsgemäße Reinigungsprozess erfolgt noch effizienter, wenn das Substrat gemäß einer vorteilhaften Ausführungsform der Erfindung während der Beaufschlagung mit Ultraschall im Lösungsmittel gedreht wird. In einer noch bevorzugteren Ausführungsform sind die Kavitäten/Vias während der Ultraschallbeaufschlagung im Lösungsmittelbad und der rotierenden Bewegung in Richtung Gravitation orientiert, so dass zusätzlich die Gewichtskraft auf die Verunreinigungen wirkt, soweit diese eine höhere Dichte als das Lösungsmittel aufweisen.

Durch die extrem geringe Haftung zwischen Verunreinigungen und Beschichtung ist gemäß einer vorteilhaften Ausführungsform der Erfindung eine Entfernung der Verunreinigungen auch mit Hilfe von Gasen denkbar. Die Gase werden dabei unter einem gewissen Einfallswinkel zum Substrat eingeblasen. Die Gase dringen bevorzugt in die Kavitäten/Vias ein und befördern die Verunreinigungen an die Substratoberfläche. Der Einfallswinkel des Gasstromes ist insbesondere kleiner/gleich 90°, bevorzugt kleiner 70°, noch bevorzugter kleiner 50°, am bevorzugtesten kleiner als 30°, am allerbevorzugtesten kleiner als 10°. In einer ganz besonders bevorzugten Ausführungsform wird das Gas parallel zur Substratoberfläche eingeblasen und erzeugt oberhalb der Kavitäten/Vias einen Unterdruck. Erfindungsgemäß verwendbare Gase sind insbesondere
- Luft und/oder
- Inertgase, insbesondere
   ∘ Argon und/oder
   ∘ Helium und/oder
   ∘ Stickstoff und/oder
   ∘ Kohlendioxid und/oder
   ∘ Ammoniak und/oder
- Reaktivgase, insbesondere
   ∘ Wasserstoff und/oder
   ∘ Sauerstoff und/oder
   ∘ Kohlenmonoxid.

In einer noch bevorzugteren Ausführungsform wird das Substrat, insbesondere bei einem relativ zum Substrat nahezu parallelen Gasstrom, während der Beaufschlagung mit dem Gas relativ zum Gasstrom gedreht. Bei einem relativ zum Substrat nahezu normalen Gasstrom wird das Substrat während der Beaufschlagung mit dem Gas relativ zum Gasstrom bevorzugt translatorisch bewegt. Denkbar ist auch eine Kombination von rotatorischer und translatorischer Bewegung des Substrats relativ zum Gasstrom.

Insbesondere im Anschluss an die Reinigung oder gleichzeitig mit der Reinigung erfolgt gemäß einem weiteren, insbesondere eigenständigen Erfindungsaspekt eine Entfernung der Beschichtung von den Kavitäten/Vias des Halbleitersubstrats, wobei die Beschichtung wie vorbeschrieben aufgebracht und aufgebaut ist.

Besonders bevorzugt erfolgt die Entfernung durch Einbringen eines oder bevorzugt mehrerer beschichteter Substrate in ein mit einem Lösungsmittel zur Lösung des Beschichtungsmaterials gefüllten Lösungsmittelbads. Auf eine Rotation des Halbleitersubstrats um seine eigene Achse kann dabei insbesondere verzichtet werden. Die Einwirkung von Ultraschall und/oder die Rotation des Substrats um eine Achse während es in einem Lösungsmittelbad liegt, kann die Entfernung des Beschichtungsmaterials beschleunigen.

Die Entfernung des Beschichtungsmaterials kann daher insbesondere durch Ultraschallbeaufschlagung des Lösungsmittels im Lösungsmittelbad unterstützt werden.

Obwohl die Reinigung der Substrate mit nasschemischen Methoden denkbar ist, erfolgt eine Reinigung des Beschichtungsmaterials mit größerem Vorzug mit Plasma. Alternative Reinigungsverfahren sind:
- Chemisch, insbesondere
   ∘ Mit Lösungsmittel, bevorzugt
   ■ Gasförmig oder
   ■ Flüssig
- Plasma
- Physikalisch, insbesondere
   ∘ Plasma, bevorzugt
   ■ Induktives Plasma oder
   ■ Kapazitives Plasma oder
   ■ Remoteplasma.

Weitere Vorteile, Merkmale und Einzelheiten der Erfindung ergeben sich aus der Beschreibung bevorzugter Ausführungsbeispiele sowie anhand der Zeichnungen. Diese zeigen in:
- Fig.1: eine Querschnittsansicht eines erfindungsgemäßen Halbleitersubstrats mit Kavitäten,
- Fig.2: ein vergrößerter Ausschnitt der Kavitäten aus Figur 1 nach einer Beschichtung mit einem erfindungsgemäßen Beschichtungsmaterial,
- Fig.3: ein erfindungsgemäßer Schritt einer Ausführungsform der vorliegenden Erfindung,
- Fig.4a: ein erster Schritt einer ersten Ausführungsform des erfindungsgemäßen Verfahrens,
- Fig.4b: ein zweiter Schritt einer ersten Ausführungsform des erfindungsgemäßen Verfahrens,
- Fig.4c: ein dritter Schritt einer ersten Ausführungsform des erfindungsgemäßen Verfahrens,
- Fig.4d: ein vierter Schritt einer ersten Ausführungsform des erfindungsgemäßen Verfahrens und
- Fig.4e: ein fünfter Schritt einer ersten Ausführungsform des erfindungsgemäßen Verfahrens.

In den Figuren sind gleiche oder gleichwirkende Bauteile mit den gleichen Bezugszeichen gekennzeichnet. Die Zeichnungen zeigen nur schematisch die erfindungsgemäßen Ausführungsformen und sind nicht maßstabsgetreu. So sind vor allem die relativen Dicken des Beschichtungsmaterials 3, und der Substrate 1 unverhältnismäßig zueinander, genauso wie das Verhältnis der genannten Dicken zum Durchmesser der Substrate 1.

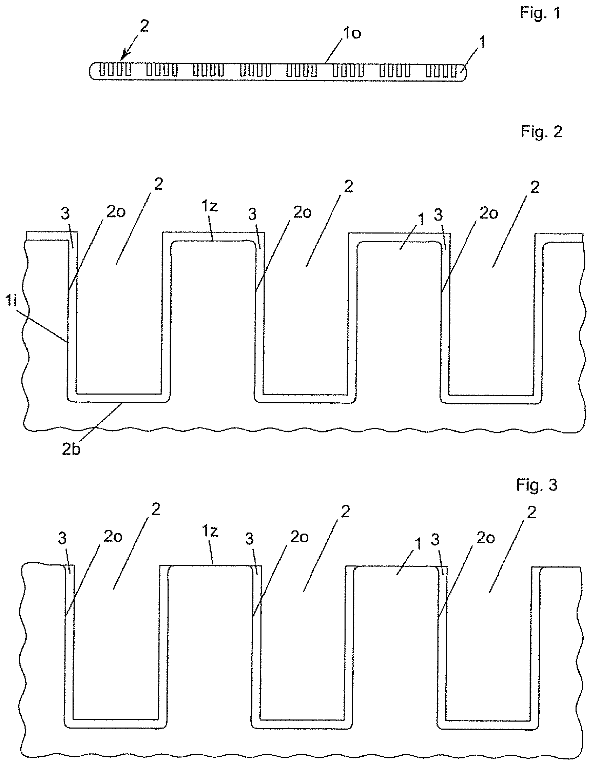

In einer ersten Form gemäß Figur 2 wird ein, als Schutzschicht vor Verunreinigungen vorgesehenes Beschichtungsmaterial 3, insbesondere in einem Schleuderbelacker, vollständig auf eine Oberfläche 1o eines Halbleitersubstrats 1 aufgetragen. Das Beschichtungsmaterial 3 dringt während des Beschichtungsprozesses in Kavitäten 2 ein. Das Beschichtungsmaterial 3 bedeckt nicht nur eine Oberfläche 2o der Kavitäten 2, sondern auch außenliegende Zwischenflächen 1z der Substratoberfläche 1o. Damit ist die erfindungsgemäße Beschichtung der Oberfläche 2o der Kavitäten 2 abgeschlossen. Diese nicht erfindungsgemäße Ausführungsform ist insbesondere dann geeignet, wenn die Substratoberfläche 1o außerhalb der Kavitäten 2 so weiterprozessiert wird, dass das Beschichtungsmaterial 3 an den Zwischenflächen 1z nicht stört. Vor allem bei Rückschleifprozessen, Rückdünnprozessen, Ätzprozessen wäre eine solche, einfache Ausführungsform denkbar.

In einer zweiten erfindungsgemäßen Ausführungsform gemäß Figur 3 wird das Beschichtungsmaterial 3, insbesondere in einem Schleuderbelacker, aufgetragen. Nachdem das Beschichtungsmaterial 3 in die Kavitäten 2 eingedrungen ist, werden, insbesondere unmittelbar anschließend, ein Abschleuderprozess, insbesondere mit hoher Drehzahl , und/oder eine Reinigung ausschließlich der Zwischenflächen 1z der Oberfläche 1o des Halbleitersubstrats 1 mit einem Lösungsmittel für das Beschichtungsmaterial durchgeführt. Die Drehzahl ist insbesondere höher als 1 rpm (engl.: roundsper-minute), insbesondere größer als 10 rpm, mit Vorzug größer als 100 rpm, mit größerem Vorzug größer als 1000 rpm.

Die Drehzahlen des Schleuderbelackers wird so gewählt, dass das Lösungsmittel für das Beschichtungsmaterial 3 nicht in die Kavitäten 2 eindringt, so dass das erfindungsgemäße Beschichtungsmaterial 3 zumindest überwiegend, vorzugsweise praktisch vollständig, in den Kavitäten 2 verbleibt. Somit sind ausschließlich die Kavitäten 2 mit dem erfindungsgemäßen Beschichtungsmaterial 3 beschichtet.

Denkbar ist auch eine nach der Beschichtung des Beschichtungsmaterials 3, durchgeführte, nachträgliche Abtragung des Beschichtungsmaterials 3 an den Zwischenflächen 1z durch jeden beliebigen physikalischen und/oder chemischen Prozess.

Die Substratoberfläche 1o außerhalb der Kavitäten 2 ist, insbesondere vollständig, von dem Beschichtungsmaterial 3 befreit und kann daher beliebig weiterbehandelt oder -bearbeitet werden.

Während der weiteren Prozessierung der Substratoberfläche 1o können Verunreinigungen in die Kavitäten 2, insbesondere ein Temporärkleber während eines Temporärbonds, eindringen. Ein Anhaften an einem Innenumfang 2i oder einem Boden 2b der Kavitäten 2 wird durch das gering adhäsive Beschichtungsmaterial 3 verhindert oder zumindest erschwert, so dass die Verunreinigungen leicht bzw. leichter wieder entfernbar sind.

Nach der Bearbeitung des Halbleitersubstrats 1 erfolgt eine erfindungsgemäße Reinigung der Kavitäten 2. Auf Grund der erfindungsgemäßen Verwendung des Beschichtungsmaterials 3 können die Verunreinigungen leicht, schnell, billig und energieeffizient aus den Kavitäten 2 entfernt werden.

Nach der Reinigung der Kavitäten 2 erfolgt die vollständige Entfernung des Beschichtungsmaterials 3 aus den Kavitäten 2. Mit Vorzug wird das Beschichtungsmaterial 3 zumindest teilweise während des Reinigungsprozesses der Kavitäten, insbesondere aber nach der vollständigen Entfernung aller Verunreinigungen entfernt.

Die Reinigung der Kavitäten 2 findet dabei mit Vorzug in einem Lösungsbad statt, mit besonderem Vorzug werden mehrere Halbleitersubstrate 1 in einem Batchprozess in einem Lösungsmittelbad gelagert. Die Temperatur eines im Lösungsmittelbad vorliegenden Lösungsmittels zur Lösung des Beschichtungsmaterials 3 wird insbesondere größer als 30°C, mit Vorzug größer als 50°C, mit größerem Vorzug größer als 75°C, mit größtem Vorzug größer als 100°C eingestellt.

In einer besonderen Ausführungsform werden die Halbleitersubstrate 1 mit den zu reinigenden Kavitäten 2 mit Ultraschall beaufschlagt. Die Ultraschallsender können dabei Ultraschallwellen erzeugen, deren Ausbreitungsrichtung normal auf die Substratoberfläche oder quer zur Substratoberfläche liegt. Denkbar wäre auch eine Beschallung der Halbleitersubstrate 1 durch Ultraschallwellen, deren Ausbreitungsrichtung zwischen der Normalen und einer Parallelen zur Substratoberfläche liegt.

Die bevorzugt zu verwendeten Chemikalien für das Lösungsmittel hängen in erster Linie von der Art der Verunreinigung ab. Vor allem bei der Verunreinigung der Kavitäten 2 durch einen Temporärkleber werden entsprechende Lösungsmittel für den Temporärkleber bevorzugt. Das sind vor allem, aber nicht ausschließlich, Limonene beinhaltende Lösungsmittel.

Weitere erfindungsgemäß denkbare Lösungsmittel wären:
- Organische Lösungsmittel
   ∘ Azeton
   ∘ Isopropanol,
   ∘ PGMEA
   ∘ Mesitylen
   ∘ Limonin
   ∘ Isododecan
- Anorganische Lösungsmittel
   ∘ Wasser

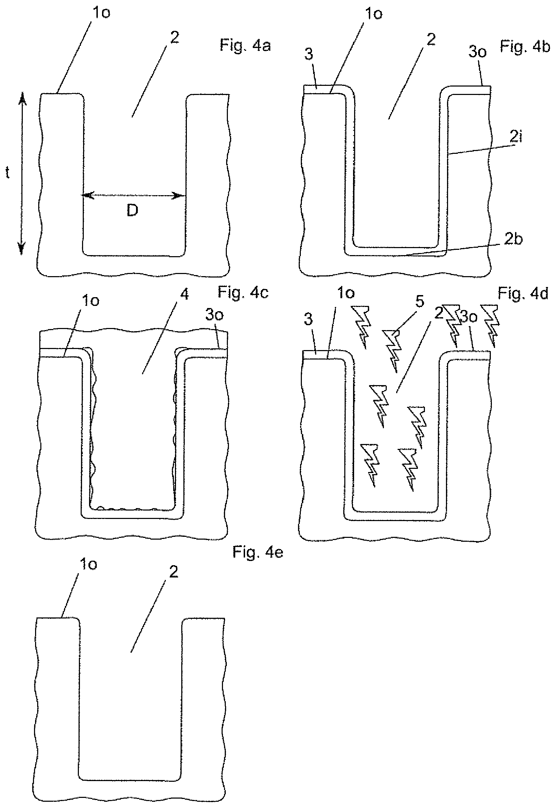

Jedes Halbleitersubstrat 1 mit seiner Substratoberfläche 1o besitzt mindestens eine Kavität 2. Bei der Kavität 2 handelt es sich in einem besonderen Fall um einen Via (Figur 4a). Ein Via ist vor allem durch das große Durchmesser-zu-Tiefe-Verhältnis D:t ausgezeichnet. Vias sind Kavitäten mit einem Durchmesser-zu-Tiefe-Verhältnis von 1:1, mit Vorzug mehr als 1:2, mit größerem Vorzug mehr als 1:10. Mit größtem Vorzug mehr als 1:50, mit allergrößtem Vorzug mehr als 1:100. Allgemein können Kavitäten, die dann nicht mehr als Vias bezeichnet werden, auch ein Durchmesser-zu-Tiefe-Verhältnis von 1:1, mit Vorzug mehr als 2:1, mit größerem Vorzug mehr als 10:1. Mit größtem Vorzug mehr als 50:1, mit allergrößtem Vorzug mehr als 100:1 besitzen.

In einem ersten Prozessschritt wird die Substratoberfläche 1o mit einem Beschichtungsmaterial 3 beschichtet (Figur 4b). Die Beschichtung erfolgt mit einer oben genannten Beschichtungsmethode, insbesondere durch Aufschleudern.

Eine Oberfläche 3o des Beschichtungsmaterials 3 besitzt eine geringe Adhäsionseigenschaft zu anderen Materialien.

In einem weiteren Prozessschritt wird das Halbleitersubstrat 1 mit einem Material bearbeitet, hier durch Beaufschlagung mit einem Kleber 4, insbesondere einen Kleber für das Temporärbonden. Die Bearbeitung führt insbesondere dazu, dass der Kleber 4 in die Kavitäten 2 eindringt (siehe Figur 4c).

Nach der erfolgten Prozessierung des Halbleitersubstrats 1 wird der Kleber 4 durch Reinigungsmittel 5 aus den Kavitäten 2 entfernt. Als Reinigungsmittel 5 werden insbesondere um chemische Lösungsmittel und/oder Gase und/oder Plasma und/oder Ultraschallwellen und/oder Licht verwendet.

Durch die erfindungsgemäße Anwendung des niedrig adhäsiven Beschichtungsmaterials 3 ist die Entfernung der Verunreinigungen wie des Klebers 4 in sehr kurzer Zeit mit sehr geringem Energieaufwand möglich.

Nach der durchgeführten Entfernung des Klebers 4 erfolgt die Entfernung der Schutzschicht 3 (Figur 4e). Mit besonderem Vorzug wird das Beschichtungsmaterial 3 bereits während des Reinigungsprozesses (Figur 4d), insbesondere nach der Entfernung des Klebers 4, entfernt.

Die erfindungsgemäß bevorzugte Methode zur Entfernung des Beschichtungsmaterials 3 ist die Anwendung von Plasma, insbesondere Sauerstoffplasma.

### Bezugszeichenliste

- 1: Halbleitersubstrat
- 1o: Oberfläche des Halbleitersubstrats
- 1z: Zwischenflächen
- 2: Kavitäten
- 2b: Boden
- 2i: Innenumfang
- 2o: Oberfläche der Kavitäten
- 3: Beschichtungsmaterial
- 3o: Oberfläche des Beschichtungsmaterials
- 4: Kleber
- 5: Reinigungsmittel
- d: Beschichtungsdicke
- D: mittlerer Durchmesser

## Patentansprüche

1. Verfahren zur temporären Beschichtung von ein Halbleitersubstrat (1) zumindest teilweise durchsetzenden, für eine permanente Beschichtung und/oder Bestückung vorgesehenen Kavitäten (2) mit einem temporär auf den Seitenwänden und am Boden der Kavitäten aufgebrachten Beschichtungsmaterial (3) vor Bearbeitungsschritten zur Bearbeitung mindestens einer Oberfläche (1o) des Halbleitersubstrats (1), wobei das Beschichtungsmaterial (3) aus einem hochadhäsiven Teil, der an der Oberfläche der Kavitäten (2) anhaftet, und einem für Verunreinigungen niedrigadhäsiven Teil, der in das Innere der Kavitäten (2) zeigt und damit mit Verunreinigungen in Kontakt kommt, gebildet ist, wobei das Beschichtungsmaterial (3) bei der Beschichtung zusätzlich an, zwischen den Kavitäten (2) verlaufenden Zwischenflächen (1z) des Halbleitersubstrats (1) aufgebracht wird, wobei das Beschichtungsmaterial (3) an den Zwischenflächen (1z) nach der Beschichtung entfernt wird, ohne das in den Kavitäten (2) aufgebrachte Beschichtungsmaterial (3) zu entfernen, wobei das Beschichtungsmaterial (3) an den Zwischenflächen (1z) durch Abschleudern, zumindest teilweise, entfernt wird.

2. Verfahren gemäß Anspruch 1, bei dem das Beschichtungsmaterial (3) zumindest auf einen Innenumfang (2i) und einen Boden (2b) der Kavitäten (2) aufgebracht wird.

3. Verfahren zur Reinigung eines mit einem Verfahren nach einem der vorhergehenden Ansprüche beschichteten und mit Bearbeitungsschritten bearbeiteten Halbleitersubstrats (1), mit folgenden Schritten:
- Beschichten des Halbleitersubstrats (1) mit einem Verfahren gemäß einem der vorhergehenden Ansprüche,
- Bearbeitung des Halbleitersubstrats (1),
- Reinigung des Halbleitersubstrats (1).

4. Verfahren zur Entfernung einer temporären Beschichtung von Kavitäten (2) eines Halbleitersubstrats (1), wobei die Beschichtung nach einem Verfahren gemäß einem der vorhergehenden Ansprüche 1 oder 2 aufgebracht ist/wird und wobei, insbesondere unmittelbar, anschließend eine permanente Beschichtung und/oder Bestückung der Kavitäten (2) erfolgt, mit folgenden Schritten:
- Beschichtung des Halbleitersubstrats (1) mit einem Verfahren gemäß der Ansprüche 1 oder 2,
- Entfernung der temporären Beschichtung,
- permanente Beschichtung und/oder Bestückung der Kavitäten (2).

5. Verfahren nach Anspruch 4, wobei die Entfernung nach einer Reinigung erfolgt.

6. Verfahren nach Anspruch 4 oder 5, wobei die Entfernung durch Einbringen eines oder bevorzugt mehrerer beschichteter Halbleitersubstrate (1) in ein mit einem Lösungsmittel zur Lösung des Beschichtungsmaterials (3) gefüllten Lösungsmittelbad erfolgt.

7. Verfahren nach Anspruch 6, wobei das/die Halbleitersubstrate (1) in dem Lösungsmittelbad mit Ultraschall beaufschlagt werden.

## Claims

1. Method for temporary coating of cavities (2), which are at least partially running through a semiconductor substrate (1) and provided for a permanent coating and/or equipping, with a temporarily applied coating material (3) on the side walls and on the bottom of the cavities (2) before processing steps for processing at least one surface (1o) of the semiconductor substrate (1), wherein the coating material (3) is formed from a high-adhesive part, which adheres to the surface of the cavities (2), and a for contaminants low-adhesive part, which points into the interior of the cavities (2) and comes into contact with the contaminants, wherein the coating material (3) is applied in the case of the coating in addition at intermediate surfaces (1z) of the semiconductor substrate (1) running between the cavities (2), wherein the coating material (3) is removed at the intermediate surfaces (1z) after the coating without removing the coating material (3) applied in the cavities (2), wherein the coating material (3) is removed at the intermediate surfaces (1z) at least partially by centrifuging,

2. Method according to Claim 1, in which the coating material (3) is applied at least on an inner periphery (2i) and a base (2b) of the cavities (2).

3. Method for cleaning a semiconductor substrate (1) that is coated with a method according to one of the preceding claims and that is processed with processing steps, with the following steps:
- Coating the semiconductor substrate (1) using a method according to one of the preceding claims,
- Processing the semiconductor substrate (1),
- Cleaning the semiconductor substrate (1).

4. Method for removing a temporary coating of cavities (2) of a semiconductor substrate (1), whereby the coating is applied according to a method in accordance with one of the preceding claims 1 or 2 and whereby, in particular immediately afterwards, a permanent coating and/or equipping of the cavities (2) is carried out, with the following steps:
- Coating the semiconductor substrate (1) using a method according to claim 1 or 2,
- Removing the temporary coating,
- permanent coating and/or equipping of the cavities (2).

5. Method according to Claim 4, whereby the removal is done after a cleaning.

6. Method according to Claim 4 or 5, whereby the removal is done by introducing one or preferably multiple coated semiconductor substrates (1) into a solvent bath filled with a solvent for dissolving the coating material (3).

7. Method according to Claim 6, whereby the semiconductor substrate(s) (1) in the solvent bath are exposed to ultrasound.

## Revendications

1. Procédé pour le placage temporaire de cavités (2) traversant au moins partiellement un substrat de semi-conducteur (1), prévues pour un placage et/ou une implantation permanente, avec un matériau de placage (3) appliqué temporairement sur les parois latérales et sur le fond des cavités avant des étapes de traitement pour le traitement d'au moins une surface (1o) du substrat de semi-conducteur (1), dans lequel le matériau de placage (3) est formé d'une partie hautement adhésive qui adhère à la surface des cavités (2) et une partie moins adhésive pour les impuretés qui est orientée vers l'intérieur des cavités (2) et vient ainsi en contact avec des impuretés, dans lequel le matériau de placage (3), lors du placage, est appliqué en plus sur des surfaces intermédiaires (1z) du substrat de semi-conducteur (1) passant entre les cavités (2), dans lequel le matériau de placage (3) sur les surfaces intermédiaires (1z) est enlevé après le placage sans enlever le matériau de placage (3) appliqué dans les cavités (2), dans lequel le matériau de placage (3) sur les surfaces intermédiaires (1z) est enlevé, au moins partiellement, par turbinage.

2. Procédé selon la revendication 1, dans lequel le matériau de placage (3) est appliqué au moins sur un pourtour intérieur (2i) et un fond (2b) des cavités (2).

3. Procédé de nettoyage d'un substrat de semi-conducteur (1) revêtu selon l'une des revendications précédentes et traité par des étapes de traitement, comprenant les étapes suivantes :
- placage du substrat de semi-conducteur (1) avec un procédé selon l'une des revendications précédentes,
- traitement du substrat de semi-conducteur (1),
- nettoyage du substrat de semi-conducteur (1).

4. Procédé d'enlèvement d'un placage temporaire de cavités (2) d'un substrat de semi-conducteur (1), dans lequel le placage est appliqué par un procédé selon une des revendications précédentes 1 ou 2 et dans lequel, en particulier directement, un placage permanent et/ou une implantation des cavités (2) est effectué, avec les étapes suivantes :
- placage du substrat de semi-conducteur (1) avec un procédé selon les revendications 1 ou 2,
- enlèvement du placage temporaire,
- placage permanent et/ou implantation des cavités (2).

5. Procédé selon la revendication 4, dans lequel l'enlèvement est effectué après un nettoyage.

6. Procédé selon la revendication 4 ou 5, dans lequel l'enlèvement est effectué par introduction d'un ou de préférence plusieurs substrat(s) de semi-conducteur (1) revêtu(s) dans un bain de solvant rempli d'un solvant pour dissoudre le matériau de placage (3).

7. Procédé selon la revendication 6, dans lequel le(s) substrat(s) de semi-conducteur (1) reçoi(ven)t des ultra-sons dans le bain de solvant.
